# EUROPÄISCHE PATENTSCHRIFT

(11) **EP 1 341 306 B1**
(45) Veröffentlichungstag und Bekanntmachung des Hinweises auf die Patenterteilung: **10.05.2006**
(21) Anmeldenummer: 02004453.3
(22) Anmeldetag: 27.02.2002
(51) Int. Cl.: H03K 17/96

(54) **Elektrische Schaltung für ein kapazitives Sensorelement**
Circuit for a capacitive sensor element
Circuit pour un capteur à capacitance variable

(43) Veröffentlichungstag der Anmeldung: 03.09.2003
(73) Patentinhaber: E.G.O. ELEKTRO-GERÄTEBAU GmbH, 75038 Oberderdingen (DE)
(72) Erfinder: Supper, Bernd, 71229 Leonberg (DE); Stäble Reiner, 75038 Oberderdingen (DE)
(74) Vertreter: Patentanwälte Ruff, Wilhelm, Beier, Dauster & Partner

(56) Entgegenhaltungen:
- DE-A- 19 701 899
- RO-B- 112 921
- US-A- 5 585 733
- PATENT ABSTRACTS OF JAPAN vol. 2000, no. 16, 8. Mai 2001 (2001-05-08) & JP 2001 027655 A (HORIBA LTD), 30. Januar 2001 (2001-01-30)

## Beschreibung

### Anwendungsgebiet und Stand der Technik

Die Erfindung betrifft eine elektrische Schaltung für wenigstens ein kapazitives Sensorelement. Insbesondere soll mit der Schaltung ein solches Sensorelement eines Berührungsschalters angesteuert und eine erfolgte Betätigung ausgewertet und erkannt werden.

Eine derartige Schaltung ist beispielsweise aus der DE 197 06 167 A1 bekannt. Hierbei ist zwar der Schaltungsaufwand bereits relativ reduziert. Es wird jedoch angestrebt, den Schaltungsaufwand weiter zu reduzieren.

### Aufgabe und Lösung

Der Erfindung liegt die Aufgabe zugrunde, eine eingangs genannte Schaltung zu schaffen, mit der der schaltungstechnische Aufwand zur Ansteuerung und Auswertung eines kapazitiven Sensorelementes weiter reduziert wird. Des weiteren soll die Störanfälligkeit verbessert werden, insbesondere auch bei Schwankungen der Versorgungsspannung für die Schaltung.

Gelöst wird diese Aufgabe durch eine Schaltung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Erfindungsgemäß ist die Schaltung als an sich bekannte Switch-Capacitor-Schaltung zur Ansteuerung und Auswertung des Sensorelementes ausgebildet. Dazu weist sie einen Microcontroller auf. Das Sensorelement befindet sich in einem Sensorzweig als Teil der Schaltung. Der Sensorzweig weist des weiteren den Ladekondensator auf. Beim Prinzip der Switch-Capacitor-Schaltung wird zuerst das Sensorelement aufgeladen in einem ersten Schritt und in einem zweiten Schritt der Ladekondensator wiederum mit der Ladung des Sensorelements aufgeladen. Die Kapazität des Sensorelements ist dabei erheblich niedriger gewählt als diejenige des Ladekondensators. So ist eine große Anzahl von Umladevorgängen notwendig, bis der Ladekondensator so weit aufgeladen ist, dass eine bestimmte Spannung an dem Ladekondensator erreicht ist. Diese bestimmte Spannung ist vorzugsweise die Schaltschwelle des Microcontrollers bzw. der Schaltung, kann aber auch eine andere Spannung sein.

Wird nun das Sensorelement betätigt, so vergrößert sich seine Kapazität erheblich. Dadurch kann es mehr Ladung aufnehmen und die Anzahl der notwendigen Umladevorgänge auf den Ladekondensator bis zum Erreichen der Schaltschwelle sinkt deutlich. Diese verringerte Anzahl von Umladevorgängen wird detektiert und als Betätigung des Sensorelements bzw. des Berührungsschalters gewertet.

Zur erfindungsgemäßen Verbesserung weist die Schaltung bzw. der Microcontroller eine Referenzschaltung auf, in der eine Referenzkapazität vorhanden ist. Diese Referenzkapazität steht in einem bekannten Verhältnis zu dem Sensorelement im unbetätigten Zustand. Des weiteren ist ein Referenzladekondensator in der Referenzschaltung vorgesehen. Hierdurch wird ein sogenannter Referenzzweig gebildet.

Erfindungsgemäß wird, ähnlich wie das Sensorelement, die Referenzkapazität in einem ersten Schritt aufgeladen. Diese Ladung wird in einem zweiten Schritt auf den Referenzladekondensator umgeladen so lange, bis die Schaltschwelle am Referenzladekondensator erreicht ist. Das Verhältnis zwischen Referenzkapazität und Sensorelement ist bekannt. So kann jeweils die Anzahl der Umladevorgänge im Referenzzweig, verrechnet mit dem Verhältnis zwischen Sensorelement und Referenzkapazität, mit der Zahl der Umladevorgänge im Sensorzweig verglichen werden. Damit kann ein Schwanken der Versorgungsspannung und somit der Schaltschwelle eliminiert werden. Somit kann erfindungsgemäß eine größere Störsicherheit der Schaltung bei sehr einfacher Ausführung erreicht werden. Insbesondere die größere Unabhängigkeit von Schwankungen der Versorgungsspannung hat den Vorteil, dass die Spannungsversorgung der Schaltung einfacher ausgebildet sein kann. Das kann beträchtlichen Aufwand ersparen. Wie auch hieraus zu erkennen ist, liegt der große Vorteil einer solchen Referenzschaltung darin, dass auf unterschiedliche Art und Weise störende Einflüsse auf die Schaltung unterdrückt bzw. kompensiert werden können. Beispielsweise kann ein Driften der Temperatur ausgeglichen werden, da Ladekondensator und Referenzladekondensator in die gleiche Richtung driften.

Üblicherweise hat das Schwanken der Versorgungsspannung den Nachteil, dass davon auch die Schaltschwelle betroffen ist. Schwankt die Schaltschwelle, schwankt die Anzahl der notwendigen Umladevorgänge. Dies macht wiederum das eindeutige Detektieren einer Betätigung schwierig. Die Schwankung der Versorgungsspannung kann bei einfachen Schaltungen bis zu 20% betragen. Dies hat bereits einen deutlich spürbaren Einfluss auf die Schaltschwelle und somit die Funktionsgenauigkeit beispielsweise eines Berührungsschalters.

Anstelle der Schaltschwelle kann, wie oben ausgeführt, auch eine beliebige Spannung genommen werden als Vergleichswert. So kann beispielsweise mit einem Komparator oder einem AD-Wandler auch ein anderer Wert genommen werden. Die Schaltschwelle kann bei Erreichen einer bestimmten Spannung von 0 Volt aus liegen. Alternativ kann sie durch eine von beispielsweise 5 Volt absinkende Spannung erreicht werden.

Die Referenzkapazität kann einerseits in dem Microcontroller selbst vorgesehen sein, beispielsweise bereits bauartspezifisch. Hier ist es lediglich notwendig, für einen bestimmten Typ von Microcontroller die Referenzkapazität zu ermitteln bzw. das zuvor genannte Verhältnis zu der Kapazität des Sensorelementes zu bestimmen.

Alternativ kann als Referenzkapazität ein separater Referenzkondensator vorgesehen sein. Hier bietet es sich an, die Referenzschaltung in einem separaten Referenzzweig zu realisieren. Dieser kann vorteilhaft im wesentlichen identisch zu einem Sensorzweig ausgebildet sein. Hierzu kann die Referenzkapazität als gegen Masse geschalteten Kondensator vorgesehen sein. Des weiteren ist der Referenzladekondensator enthalten, dessen Kapazität bevorzugt derjenigen des Ladekondensators des Sensorzweigs entspricht.

Bevorzugt wird die Referenzkapazität, insbesondere als separater Referenzkondensator, in etwa in der Größenordnung des unbetätigten Sensorelements gewählt. Besonders bevorzugt sind sie gleich. Dadurch ergibt sich eine an sich gleiche Anzahl von Umladevorgängen im unbetätigten Zustand des Sensorelements zum Erreichen der Schaltschwelle.

Eine solche Kapazität des Sensorelements bzw. des Referenzkondensators kann im unbetätigten Zustand bei einigen wenigen pF liegen. Als vorteilhaft werden hier ca. 5 pF angesehen. Die Kapazität des Ladekondensators wiederum wird erheblich höher gewählt. Beispielsweise liegt sie zwischen 10 nF und einem µF. Als besonders vorteilhaft werden hier ca. 100 nF angesehen. Die vorgenannte Versorgungsspannung des Microcontrollers sollte vorteilhaft bei 5 Volt liegen.

In weiterer Ausgestaltung der Erfindung kann ein Microcontroller mehrere Sensorzweige aufweisen. So ist es möglich, mit einem Microcontroller mehrere Sensorelemente, beispielsweise einer in sich geschlossenen Steuereinheit mit einer Vielzahl von Berührungsschaltern, vorzusehen.

Des weiteren kann die Schaltung wenigstens einen Widerstand zur Verbesserung der EMV-Eigenschaften aufweisen. So können Störungen gedämpft werden. Vorteilhaft wird der Widerstand in der Referenzschaltung vorgesehen. Möglich ist es des weiteren auch, einen Widerstand in dem Sensorzweig vorzusehen.

Als Sensorelement kann grundsätzlich ein beliebiges kapazitives Sensorelement zum Einsatz kommen. Vorteilhaft ist es ein dreidimensionaler, raumformveränderlicher Körper aus leitfähigem Kunststoff, beispielsweise Schaumstoff. Ein Sensorelement ist besonders bevorzugt dazu ausgebildet, an der Unterseite einer Abdeckung angedrückt zu werden. Dabei kann die Oberseite der Abdeckung eine Berühroberfläche für den Berührungsschalter bilden.

Bei einer möglichen Ausführung der Erfindung können mehrere Sensorzweige an jeweils eigene Eingänge oder Ports des Microcontrollers angeschlossen sein. Dies wird vorteilhaft dann gewählt, wenn die Anzahl der Sensorzweige nicht besonders groß ist, beispielsweise zwei bis vier.

Bei einer alternativen Ausführungsform der Erfindung, insbesondere mit einer Vielzahl von Sensorzweigen, können mehrere Sensorzweige über Schalter mit einem Multiplexverfahren mit dem Microcontroller verbunden werden. Dies ermöglicht an sich eine sehr hohe Anzahl von Sensorzweigen oder Sensorelementen pro Microcontroller. Als Schalter können unterschiedliche Typen zum Einsatz kommen. Vorteilhaft sind es Analogschalter. Ebenso können auch Transistoren oder Relais verwendet werden. Derartige Schalter sowie eine Multiplexung vorzusehen ist vom Aufwand her nicht besonders hoch. Vorteilhaft ist hier vorgesehen, dass auch die Referenzschaltung über einen Schalter mit dem Microcontroller verbunden ist, wobei hier keine Multiplexung nötig ist. Dadurch können Einflüsse der Schalter, die in der Regel beispielsweise eine gewisse Kapazität aufweisen, ausgeglichen werden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Ausführungsbeispiele der Erfindung sind in den Zeichnungen dargestellt und werden im folgenden näher erläutert.

### Kurzbeschreibung der Zeichnungen

Ausführungsbeispiele der Erfindung sind in den Zeichnungen dargestellt und werden im folgenden näher erläutert. In den Zeichnungen zeigen:
- Fig. 1: eine schematische Darstellung einer Schaltung mit Sensorzweig und Referenzzweig beim Entladen der Kondensatoren,
- Fig. 2: die Schaltung aus Fig. 1 beim Laden des Sensorelements,
- Fig. 3: die Schaltung aus Fig. 2 beim Umladen vom Sensorelement auf den Ladekondensator und
- Fig. 4: ein Schaltungsbeispiel mit einer Vielzahl von Sensorzweigen, die über Analogschalter und Multiplexung mit dem Microcontroller verbunden sind.

### Detaillierte Beschreibung der Ausführungsbeispiele

Die Schaltungsbeispiele der Figuren sind schematisch zu verstehen und auf das funktional Nötige begrenzt, um die Erfindung zu verstehen und zu erläutern.

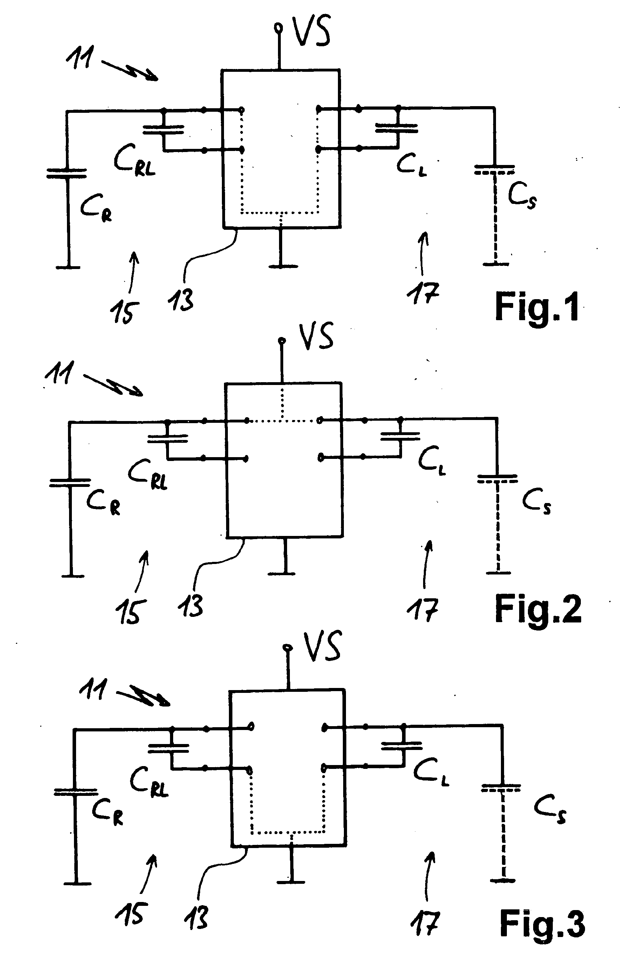

In Fig. 1 bis 3 ist jeweils eine Schaltung 11 dargestellt, die gemäß einem Ausführungsbeispiel der Erfindung ausgebildet ist. Dabei ist ein Microcontroller 13 vorgesehen, der mit einer Versorgungsspannung VS verbunden ist. An zwei Ports des Microcontrollers 13 ist auf der linken Seite ein Referenzzweig 15 angeschlossen. Dieser besteht aus einem Referenzladekondensator C_{RL} sowie einem gegen Masse geschalteten Referenzkondensator C_{R}.

Auf der rechten Seite des Mikrocontrollers 13 ist an zwei weiteren Ports ein Sensorzweig 17 angeschlossen. Hier können auch weitere, identisch ausgebildete Sensorzweige vorgesehen sein.

Der Sensorzweig 17 weist auf dem Referenzzweig 15 entsprechende Art einen Kondensator C_{L} als Ladekondensator auf. Des weiteren weist er das Sensorelement C_{S} auf. Dieses ist zum Teil gestrichelt dargestellt. Dadurch soll verdeutlicht werden, dass im wesentlichen nur im betätigten Zustand, also wenn beispielsweise ein Finger eines Benutzers anliegt, das Sensorelement C_{S} ein gegen Masse geschalteter Kondensator ist.

Die Versorgungsspannung VS kann im Bereich von 5 Volt liegen. Die Kapazitäten der Ladekondensatoren C_{L} und C_{RL} können bei 100 nF liegen. Die Kapazitäten der Sensorelemente C_{S} sowie des Referenzkondensators C_{R} können beispielsweise bei 5 pF liegen.

Durch die punktierten Linien im Mikrocontroller 13 können verschiedene interne Verschaltungszustände dargestellt werden. In Fig. 1 ist dargestellt, wie sämtliche Kapazitäten entladen werden. In Fig. 2 ist zu erkennen, wie jeweils die Sensorelemente C_{S} und die Referenzkapazität C_{R} auf die Versorgungsspannung VS aufgeladen werden.

Im nächsten Schritt in Fig. 3 wird die Ladung von den Sensorelementen C_{S} und der Referenzkapazität C_{R} auf jeweils die Ladekondensatoren C_{L} und C_{RL} umgeladen. Da die Kapazität der Ladekondensatoren um ein Vielfaches höher liegt, bei den gewählten Werten um den Faktor 20.000, sind einige tausend Ladevorgänge notwendig, um die Schaltschwelle des Mikrocontrollers 13 zu erreichen. Diese liegt in der Regel bei ungefähr 1,3 Volt. Sobald also nach einer ausreichenden Anzahl von Umladevorgängen die Ladekondensatoren auf diese 1,3 Volt aufgeladen sind, schaltet der Mikrocontroller. Die Zahl dieser Umladevorgänge kann im voraus bestimmt werden.

Wird nun das Sensorelement C_{S} betätigt, so erhöht sich seine Kapazität deutlich. Dies bedeutet, dass seine Kapazität erheblich höher liegt als diejenige der Referenzkapazität C_{R}. Damit kann es bei den Ladevorgängen eine größere Ladung speichern, die dann auf die Ladekondensatoren C_{L} umgeladen wird. Somit kann im betätigten Zustand des Sensorelements C_{S} mit weniger Umladevorgängen mehr Ladung auf die Ladekondensatoren umgeladen werden. So erreicht dieser mit einer geringeren Anzahl von Umladevorgängen als im Referenzzweig die Schaltschwelle. Da hierbei nicht mehr die absolute Anzahl der Umladevorgänge ermittelt werden muss, sondern lediglich die Anzahl der Umladevorgänge in den Sensorzweigen mit derjenigen im Referenzzweig verglichen werden muss, können Einflüsse der Schwankung der Versorgungsspannung auf die Schaltschwelle ausgeschaltet werden. Im übrigen ist zu erkennen, dass die Schaltung 11 im wesentlichen nach dem Prinzip der Switch-Capacitor-Schaltung arbeitet.

An den Mikrocontroller 13 können eine Vielzahl von Sensorzweigen 17 angeschlossen werden, sofern noch freie Ports zur Verfügung stehen.

Durch die dargestellte, erfindungsgemäße Schaltung wird nicht mehr die Schaltschwelle als absoluter Wert benötigt. Durch den Vergleich mit dem Referenzzweig, dessen Werte in bekanntem Verhältnis zu dem Sensorzweig stehen oder in einem Betätigungszustand identisch dazu sind, dient die Schaltschwelle des Mikrocontrollers für beide Schaltungszweige als Anhaltswert und somit ist ihre absolute Größe nicht entscheidend.

In weiterer Ausgestaltung der Erfindung ist es auch möglich, den Referenzkondensator C_{R} nicht als diskretes Bauteil vorzusehen. Es könnte auch eine in dem Microcontroller 13 existierende, nicht völlig vermeidbare Kapazität genutzt werden. Selbst wenn diese eine andere Kapazität aufweist als das Sensorelement C_{S}, so ist doch zumindest das Verhältnis der beiden zueinander bestimmbar. Dieses Verhältnis kann in den Vergleich der Anzahl der benötigten Umladevorgänge bis zum Erreichen der Schaltschwelle eingerechnet werden.

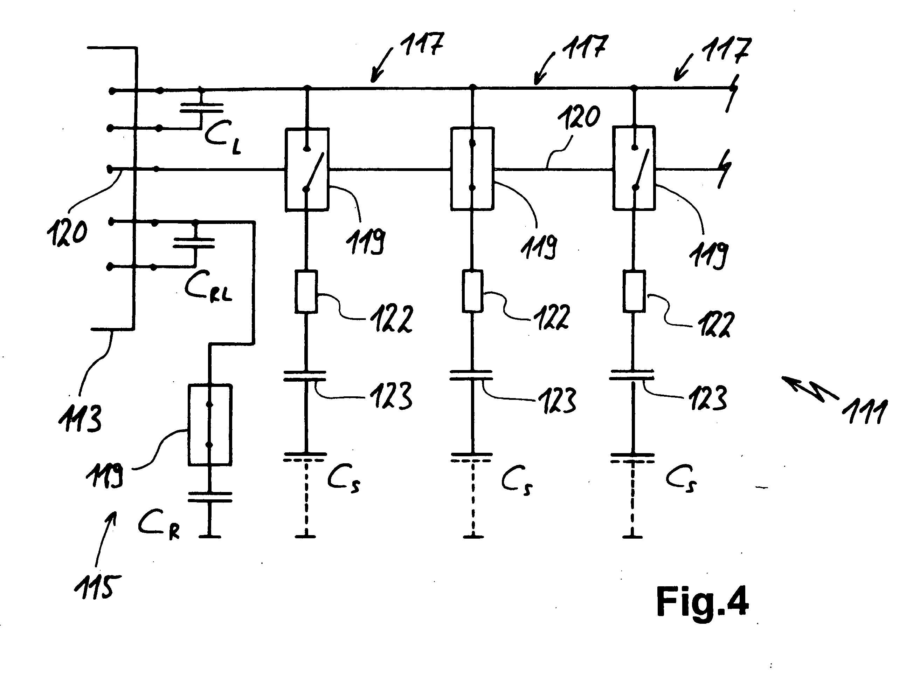

Eine weitere Möglichkeit, mehrere Sensorzweige an einem Microcontroller 13 zu betreiben, ohne dass dieser eine Vielzahl von Ports aufweist, ist in Fig. 4 dargestellt. Hier sind mehrere Sensorzweige 117 vorgesehen. Diese sind jeweils durch Analogschalter 119 mit einem Port des Microcontrollers 113 verbunden. Die Analogschalter 119 werden über eine Ansteuerung 120 angesteuert. Diese Ansteuerung erfolgt vorteilhaft nach einem Multiplexverfahren, auf das hier nicht näher eingegangen werden muss, da es nach bekannter Art realisiert werden kann. Mit einer solchen Schaltung 111 gemäß Fig. 4 kann eine Vielzahl von Sensorelementen C_{S} an einem einfachen Microcontroller 113 betrieben werden.

In den Sensorzweigen sind zusätzlich zu den Sensorelementen C_{S} Widerstände 122 sowie Kondensatoren 123 zur Verbesserung der Störeigenschaften, insbesondere der EMV-Eigenschaften, vorgesehen. Auf bekannte Weise ist ein Ladekondensator C_{L} vorgesehen.

Damit sich der Referenzzweig 115 wieder im wesentlichen identisch verhält zu den Sensorzweigen 117, ist auch in diesem neben dem Referenzkondensator C_{R} und dem Referenzladekondensator C_{RL} ein Analogschalter 119 vorgesehen. Dieser kann jedoch permanent geschlossen bleiben, da er von der Multiplexung nicht betroffen ist.

Ein weiterer Vorteil der vorgesehenen Referenzzweige 15 und 115 liegt darin, dass eine Kompensation der Temperaturempfindlichkeit der Ladekondensatoren C_{L} möglich ist.

Vorteilhaft findet eine Messung im Nulldurchgang der Netzspannung statt. Dies hat insbesondere bei nicht galvanisch getrennten Netzteilen den Vorteil, dass der Potentialunterschied zwischen dem Sensorelement und Masse, welche z.B. an dem Einbaurahmen eines Kochfeldes liegt, sehr gering ist bzw. gegen Null geht.

Ein vorteilhaft zu verwendendes Sensorelement ist beispielsweise in der DE 197 06 168 A1 beschrieben.

## Patentansprüche

1. Elektrische Schaltung für wenigstens ein kapazitives Sensorelement, insbesondere eines Berührungsschalters, wobei:
- die Schaltung als Switch-Capacitor-Schaltung für das Sensorelement ausgebildet ist und einen Microcontroller (13, 113) aufweist,
- wobei sich das Sensorelement (C_{S}) in einem Sensorzweig (17, 117) befindet mit einem Ladekondensator (C_{L}), der mit der Ladung des Sensorelements (C_{S}) aufgeladen wird bis zu einer bestimmten Spannung,
- der Sensorzweig (17, 117) mit dem Microcontroller (13, 113) verbunden ist,
- der Microcontroller (13, 113) eine Referenzschaltung (15, 115) aufweist mit einem Referenzladekondensator (C_{RL}) und einer Referenzkapazität (C_{R}), die in bekanntem Verhältnis zu dem Sensorelement (C_{S}) im unbetätigten Zustand steht, und Referenzkapazität und Sensorelement in etwa gleich groß sind,
- der Microcontroller (13, 113) die Zahl der Aufladevorgänge an dem Sensorzweig (17, 117) vergleicht mit der Zahl der Aufladevorgänge in der Referenzschaltung (15, 115) bis zum Erreichen der bestimmten Spannung,
- wobei die Referenzkapazität (C_{R}) in etwa der Kapazität des Sensorelements (Cₛ) entspricht.

2. Schaltung nach Anspruch 1, **dadurch gekennzeichnet, dass** die Referenzkapazität in dem Microcontroller (13, 113) vorgesehen ist.

3. Schaltung nach Anspruch 1, **dadurch gekennzeichnet, dass** die Referenzkapazität ein separater Referenzkondensator (C_{R}) ist und die Referenzschaltung ein separater Referenzzweig (15, 115).

4. Schaltung nach Anspruch 3, **dadurch gekennzeichnet, dass** der Referenzzweig (15, 115) im wesentlichen identisch zu dem Sensorzweig (17, 117) ausgebildet ist.

5. Schaltung nach einem der vorhergehenden Ansprüche, **dadurch gekennzeichnet, dass** die Referenzkapazität (C_{R}) und die Kapazität des Sensorelements (C_{S}) vorzugsweise gleich sind.

6. Schaltung nach einem der vorhergehenden Ansprüche, **dadurch gekennzeichnet, dass** die Kapazität des Sensorelements (C_{S}) im unbetätigten Zustand bei einigen wenigen pF liegt, vorzugsweise bei etwa 5 pF.

7. Schaltung nach einem der vorhergehenden Ansprüche, **dadurch gekennzeichnet, dass** die Kapazität des Ladekondensators (C_{L}), insbesondere auch des Referenzladekondensators (C_{RL}), zwischen 10 nF und 1 µF liegt, vorzugsweise bei ca. 100 nF.

8. Schaltung nach einem der vorhergehenden Ansprüche, **dadurch gekennzeichnet, dass** der Microcontroller (13, 113) mehrere Sensorzweige (17, 117) aufweist.

9. Schaltung nach einem der vorhergehenden Ansprüche, **gekennzeichnet durch** einen Widerstand (122) in der Schaltung (11, 111) zur Verbesserung der EMV-Eigenschaften, wobei vorzugsweise der Widerstand zumindest in der Referenzschaltung (15, 115) vorgesehen ist.

10. Schaltung nach einem der vorhergehenden Ansprüche, **dadurch gekennzeichnet, dass** das Sensorelement (Cₛ) ein dreidimensionalec, raumformveränderlicher Körper aus leitfähigem Kunststoff ist, wobei vorzugsweise das Sensorelement ausgebildet ist zum Anliegen an der Unterseite einer Abdeckung, wobei die Oberseite der Abdeckung eine Berühroberfläche für einen Berührungsschalter bildet.

11. Schaltung nach einem der vorhergehenden Ansprüche, **dadurch gekennzeichnet, dass** mehrere Sensorzweige (17) an jeweils eigene Eingänge des Microcontrollers (13) angeschlossen sind.

12. Schaltung nach einem der Ansprüche 1 bis 10, **dadurch gekennzeichnet, dass** mehrere Sensorzweige (117) über je einen Analogschalter (119) mit Multiplexung mit dem Microcontroller (113) verbunden sind, wobei vorzugsweise auch die Referenzschaltung (115) über einen Analogschalter (119) mit dem Microcontroller verbunden ist.

## Claims

1. Electric circuit for at least one capacitive sensor element, in particular of a touch switch, wherein the circuit is configured as a switch capacitor circuit for the sensor element and is provided with a microcontroller (13, 113), wherein the sensor element (C_{S}) is disposed in a sensor branch (17, 117) with a charging capacitor (C_{L}) which is charged with the charge of the sensor element (C_{S}) until it reaches a determined voltage, the sensor branch (17, 117) is connected to the microcontroller (13, 113), the microcontroller (13,113) is provided with a reference circuit (15, 115) with a reference charging capacitor (C_{RL}) and a reference capacitance (C_{R}) which are in a known ratio with the sensor element (C_{S}) in the non-triggered state, and the reference capacitance and sensor element are approximately identical, the microcontroller (13, 113) compares the number of the charge processes in the sensor branch (17, 117) with the number of the charge processes in the reference circuit (15, 115) until the predetermined voltage is reached, and wherein the reference capacitance (C_{R}) approximately corresponds to the capacitance of the sensor element (C_{S}).

2. Circuit according to claim 1, **characterised in that** the reference capacitance is provided in the microcontroller (13, 113).

3. Circuit according to claim 1, **characterised in that** the reference capacitance is a separate reference capacitor (C_{R}) and the reference circuit is a separate reference branch (15, 115).

4. Circuit according to claim 3, **characterised in that** the reference branch (15, 115) is substantially identical to the sensor branch (17, 117).

5. Circuit according to any one of the preceding claims, **characterised in that** the reference capacitance (C_{R}) and the capacitance of the sensor element (C_{S}) are preferably identical.

6. Circuit according to any one of the preceding claims, **characterised in that** the capacitance of the sensor clement (C_{S}) in the non-triggered state is in the range of a few pF, preferably at approximately 5 pF.

7. Circuit according to any one of the preceding claims, **characterised in that** the capacitance of the charging capacitor (C_{L}), in particular also of the reference charging capacitor (C_{RL}), is between 10 nF and 1 µF, preferably at approximately 100 nF.

8. Circuit according to any one of the preceding claims, **characterised in that** the microcontroller (13, 113) has a plurality of sensor branches (17, 117).

9. Circuit according to any one of the preceding claims, **characterised by** a resistor (122) in the circuit (11, 111) to improve the EMV properties, the resistor preferably being provided at least in the reference circuit (15, 115).

10. Circuit according to any one of the preceding claims, **characterised in that** the sensor element (C_{S}) is a three-dimensional, spatially deformable body made of conductive plastics material, the sensor element preferably being configured to be in contact with the bottom of a cover, the top of the cover forming the touch surface for a touch switch.

11. Circuit according to any one of the preceding claims, **characterised in that** a plurality of sensor branches (17) arc each connected to individual inputs of the microcontroller (13).

12. Circuit according to any one of claims 1 to 10, **characterised in that** a plurality of sensor branches (117) are connected to the microcontroller (113) with multiplexing via one analogue switch (119) each, the reference circuit 115 preferably also being connected to the microcontroller via an analogue switch (119).

## Revendications

1. Circuit électrique pour au moins un élément capteur capacitif, en particulier un commutateur tactile, dans lequel :
le circuit est réalisé sous forme de circuit à capacité/commutateur pour l'élément capteur et présente un microcontrôleur (13, 113),
l'élément capteur (C_{S}) se trouve dans une ramification de capteur (17, 117) avec un condensateur de charge (C_{L}), au moyen duquel la charge de l'élément capteur (C_{S}) est chargée jusqu'à une tension déterminée,
la ramification de capteur (17, 117) est reliée au microcontrôleur (13, 113),
le microcontrôleur (13, 113) comprend un circuit de référence (15, 115) avec un condensateur de chargement de référence (C_{RL}) et une capacité de référence (C_{R}), qui présente un rapport connu vis-à-vis de l'élément capteur (C_{S}) à l'état non actionné, et la capacité de référence et l'élément capteur sont approximativement égaux,
le microcontrôleur (13, 113) compare le nombre des opérations de chargement au niveau de la ramification de capteur (17, 117) au nombre des opérations de chargement dans le circuit de référence (15, 115) jusqu'à atteindre la tension déterminée, et
la capacité de référence (C_{R}) correspond approximativement à la capacité de l'élément capteur (C_{S}).

2. Circuit selon la revendication 1, **caractérisé en ce que** la capacité de référence est prévue dans le microcontrôleur (13, 113).

3. Circuit selon la revendication 1, **caractérisé en ce que** la capacité de référence est un condensateur de référence séparé (C_{R}) et le circuit de référence est une ramification de référence séparée (15, 115).

4. Circuit selon la revendication 3, **caractérisé en ce que** la ramification de référence (15, 115) est réalisée de manière sensiblement identique à la ramification de capteur (17, 117).

5. Circuit selon l'une des revendications précédentes, **caractérisé en ce que** la capacité de référence (C_{R}) et la capacité de l'élément capteur (C_{S}) sont de préférence égales.

6. Circuit selon l'une des revendications précédentes, **caractérisé en ce que** la capacité de l'élément capteur (C_{S}) à l'état non actionné est de quelques pF, de préférence d'environ 5 pF.

7. Circuit selon l'une des revendications précédentes, **caractérisé en ce que** la capacité du condensateur de charge (C_{L}), en particulier également celle du condensateur de chargement de référence (C_{RL}), est entre 10 nF et 1 µF, de préférence d'environ 100 nF.

8. Circuit selon l'une des revendications précédentes, **caractérisé en ce que** le microcontrôleur (13, 113) comprend plusieurs ramifications de capteur (17, 117).

9. Circuit selon l'une des revendications précédentes, **caractérisé par** une résistance (122) dans le circuit (11, 111) pour améliorer les propriétés de compatibilité électromagnétique, ladite résistance étant de préférence prévue au moins dans le circuit de référence (15, 115).

10. Circuit selon l'une des revendications précédentes, **caractérisé en ce que** l'élément capteur (C_{S}) est un corps tridimensionnel à forme spatiale variable en matière plastique conductrice, dans lequel l'élément capteur est réalisé de préférence pour être appliqué contre la face inférieure d'un recouvrement et la face supérieure du recouvrement forme une surface tactile pour un commutateur tactile.

11. Circuit selon l'une des revendications précédentes, **caractérisé en ce que** plusieurs ramifications de capteur (17) sont raccordées à des entrées propres respectives du microcontrôleur (13).

12. Circuit selon l'une des revendications 1 à 10, **caractérisé en ce que** plusieurs ramifications de capteur (117) sont raccordées par un commutateur analogique respectif (119) avec multiplexage au microcontrôleur (113), et de préférence le circuit de référence (115) est également raccordé au microcontrôleur via un commutateur analogique (119).
